# EUROPEAN PATENT APPLICATION

(11) **EP 2 017 878 A2**
(43) Date of publication of application: **21.01.2009**
(21) Application number: 08160554.5
(22) Date of filing: 16.07.2008
(51) Int. Cl.: H01L 21/033, H01L 21/311

(54) **Method for etching using advanced patterning film in capacitive coupling high frequency plasma dielectric etch chamber**

(30) Priority: 16.07.2007 US 778239
(71) Applicant: Applied Materials, Inc., Santa Clara, CA 95054 (US)
(72) Inventor: Wang, Judy, Cupertino, CA 95014 (US); Sung, Shing-Li, Campbell, CA 95008 (US); Ma, Shawming, Sunnyvale, CA 94086 (US)
(74) Representative: Zimmermann & Partner

(57) **Abstract**

A method for etching wafers using advanced patterning film (APF) to reduce bowing and improve bottom-to-top ratios includes providing a wafer having an APF layer into a processing chamber, wherein the processing chamber is configured with a power source operating at about 162 MHz, supplying a process gas into the chamber, applying a source power using the 162 MHz power source, and applying a bias power to the wafer. The process gas comprises hydrogen gas (H2), nitrogen gas (N2), and carbon monoxide gas (CO). The ratio of H2: N2 is about 1:1. Additionally, the wafer temperature is adjusted to improve the etching characteristics.

## Description

### BACKGROUND

Aspects of the present invention relate generally to the field of semiconductor devices and the manufacture of those semiconductor devices. More particularly, embodiments of the present invention relate to methods and apparatuses for etching Advanced Patterning Films (APF).

As computers become faster and more powerful, the semiconductor devices running those computers are becoming smaller and more complex. Many modern semiconductor devices are made of CMOS (Complimentary Metal-Oxide-Semiconductor) transistors and capacitors, in which the CMOS transistors generally include a source, drain, and gate. The gate is sometimes called a gate stack because it may include several components, such as a gate electrode and an underlying gate dielectric. Sidewall spacers (also called spacers or spacer layers) may be adjacent to the gate structure and usually include an oxide layer and a nitride layer component.

Although CMOS devices are common semiconductor devices found in many computers, they are becoming increasingly more difficult to make. One reason why it is becoming more difficult to make CMOS devices is that these devices are becoming smaller and therefore the tolerance associated with each CMOS device is becoming tighter. One method for fabricating such CMOS devices includes forming a patterned mask (e.g., photoresist mask), which includes advanced patterning films, on a material layer disposed beneath such a mask (i.e., on an underlying layer) and then etching the material layer using the patterned photoresist mask as an etch mask. Advanced Patterning Films (APF) is a strippable hardmask (an amorphous carbon/DARC stack film) that can be used to replace the spin-on ARC in trim procedures. The etch mask generally is a replica of the structure to be formed (or, etched) in the underlying layer (or layers). As such, the etch mask has the same topographic dimensions as the structures being formed in the underlying layer(s).

Manufacturing variables of an etch process may result in a broad statistical distribution (e.g., large σ, where σ is a standard deviation) for the dimensions of the structures formed within a group (e.g., batch or lot) of wafers being etched. Moreover, variability in the manufacturing process can also cause statistical distributions in structural dimensions within a single wafer.

For example, during the manufacture of CMOS devices, trenches are often etched into materials. Although it is often desirable to etch trenches that have a good aspect ratio where the opening at the top of a trench is very close in dimension to the opening at the bottom of the trench, it is difficult to obtain such results. Advanced Patterning Film^{™} (APF) available from Applied Materials, Inc. of Santa Clara, California, is very effective in improving the top-to-bottom ratio in etched trenches. The APF solution uses a dual-layer patterning film stack that combines strippable CVD carbon hardmask technology with a dielectric anti-reflective coating (DARC) to enable advanced high aspect ratio contact etching. With its high selectivity to polysilicon and oxide, APF provides exceptional control of the etching process.

Although etching processes that use APF solutions improve the aspect ratio between the top and bottom of trenches, etching with APF alone may exhibit a bowing profile where the center of the trench bows out. Additionally, although etching with APF improves the bottom-to-top ratio of etched trenches the ratio is still less than 80% in many cases. As critical dimensions become smaller these effects become more troublesome.

Therefore, what is needed is a system and method for etching trenches in semiconductor devices that takes advantages of the APF while reducing bowing and making devices having trenches with bottom-to-top ratios greater than 80%.

### BRIEF SUMMARY

In light of the above, the method according to independent claim 1, the method according to independent claim7, and the method according to independent claim 9 are provided.
Further advantages, features, aspects and details are evident from the dependent claims, the description and the drawings.
Embodiments of the present invention provide systems and methods that take advantage of etching with APF and in certain embodiments, improve the process so that bowing is reduced and bottom-to-top ratios are greater than 80%.

In one embodiment of the present invention, a method of etching an advanced pattern film (APF) includes providing a wafer including an APF layer into a processing chamber, wherein the processing chamber is configured with a power source, supplying a process gas into the chamber, applying a source power using the power source, and applying a bias power to the wafer. The process gas comprises hydrogen gas (H₂), nitrogen gas (N₂), and carbon monoxide gas (CO). In one embodiment the ratio of H₂: N₂ is about 1:1. In a typical embodiment, the power source is operating at about 162 MHz

In another embodiment of the present invention, the process gas is prepared by mixing 300 sccm of H₂, 300 sccm of N₂, and 25 - 100 sccm of CO prior to supplying the premixed process gas into the processing chamber. In a specific embodiment, about 50 sccm of CO is used.

In yet another embodiment of the present invention, the source power ranges between 0 watts and 2300 watts, in particular between 500 and 1500 watts, typically about 1000 watts.

In yet another embodiment of the present invention, the source power is about 2000 watts.

In yet another embodiment of the present invention, the bias power ranges between 0 watts and 1000 watts, in particular 200 watts and 800 watts.

In yet another embodiment of the present invention, the bias power is about 900 watts.

In yet another embodiment of the present invention, the process pressure is maintained between 20 millitorr and 200 millitorr. In one specific example, the pressure is maintained at about 100 millitorr.

In another embodiment of the present invention, a method of etching an advanced pattern film (APF) includes providing a wafer including an APF layer into a processing chamber, wherein the processing chamber is configured with a power source, supplying a process gas into the chamber, applying a source power using the power source, and applying a bias power to the wafer. The process gas comprises hydrogen gas (H₂), nitrogen gas (N₂), and carbon monoxide gas (CO). The ratio of H₂: N₂ is about 3:1. The source power can range between 0 watts and 2300 watts. For example, in one embodiment the source power is about 2000 watts. The bias power can range between 0 watts and 1000 watts. In one specific embodiment, the bias power is about 900 watts. In a typical embodiment, the power source is operating at about 162 MHz

In yet another embodiment of the present invention, the ratio of H₂: N₂ is about 3:1, and the process gas is prepared by mixing 450 sccm of H₂, 150 sccm of N₂, and 25 - 100 sccm of CO prior to supplying the process gas into the processing chamber. In a specific embodiment, about 50 sccm of CO is used.

In yet another embodiment of the present invention, the ratio of H₂: N₂ is about 3:1, and the process pressure is maintained between 20 millitorr and 200 millitorr. In one specific example, the pressure is maintained at about 100 millitorr.

In another embodiment of the present invention, a method of etching an advanced pattern film (APF) includes providing a wafer including an APF layer into a processing chamber, wherein the processing chamber is configured with a power source operating at about 162 MHz, adjusting the temperature of the wafer to be between 20 °C and 60 °C, supplying a process gas into the chamber, applying a source power using the 162 MHz power source, and applying a bias power to the wafer. The process gas comprises hydrogen gas (H₂), nitrogen gas (N₂), and carbon monoxide gas (CO). The source power can range between 0 watts and 2300 watts. For example, in one embodiment, the source power is about 2000 watts. The bias power can range between 0 watts and 1000 watts. In one specific embodiment, the bias power is about 900 watts.

In yet another embodiment of the present invention, the temperature of the wafer is set to be about 50 °C.

In yet another embodiment of the present invention, the wafer temperature is adjusted, and the H₂ and the N₂ in the process gas has a ratio of H₂: N₂ of about 1:1. In one example of this embodiment, the process gas is prepared by mixing 300 sccm of H₂, 300 sccm of N₂, and 25 - 100 sccm of CO prior to supplying the process gas into the processing chamber. In yet a more specific example about 50 sccm of CO is used.

In yet another embodiment of the present invention, the wafer temperature is adjusted, and the H₂ and the N₂ in the process gas has a ratio of H₂: N₂ of about 3:1. In one example of this embodiment, the process gas is prepared by mixing 450 sccm of H₂, 150 sccm of N₂, and 25 - 100 sccm of CO prior to supplying the process gas into the processing chamber. In yet a more specific example, about 50 sccm of CO is used.

In yet another embodiment of the present invention, the wafer temperature is adjusted, and the process pressure is maintained between 20 millitorr and 200 millitorr. In one specific example, the pressure is maintained at about 100 millitorr.
Further, a method for etching wafers using advanced patterning film (APF) is provided to reduce bowing and improve bottom-to-top ratios includes providing a wafer having an APF layer into a processing chamber, wherein the processing chamber is configured with a power source operating in particular at about 162 MHz, supplying a process gas into the chamber, applying a source power using the 162 MHz power source, and applying a bias power to the wafer. The process gas comprises hydrogen gas (H2), nitrogen gas (N2), and carbon monoxide gas (CO). The ratio of H2: N2 is about 1:1. Additionally, the wafer temperature is adjusted to improve the etching characteristics.
Additionally, a plasma processing chamber is provided adapted to etch a substrate according to the methods according to the invention, in particular comprising a substrate support and an overhead electrode connected to an RF generator.
Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:

FIG. 1 is an illustration of a capacitively coupled plasma processing tool used to etch substrates in accordance with one embodiment of the invention.

FIG. 2A is a flow chart showing the steps used to etch an APF with high photoresist mask (PR) selectivity and high etch rate using a capacitive coupling high frequency plasma dielectric etch chamber, in accordance with one embodiment of the invention.

FIG. 2B is a flow chart showing the steps of FIG. 2A used to etch an APF along with an additional step of applying a bias power, in accordance with another embodiment of the invention.

FIG. 2C is a flow chart showing the steps of FIG. 2B used to etch an APF along with an additional step of adjusting the temperature of the substrate, in accordance with another embodiment of the invention.

FIGs. 3A-3B show a gate electrode stack both before etching and after etching using etching techniques, in accordance with one embodiment of the invention.

FIG. 4 is graph showing data for the APF bottom critical dimension (BCD) as a function of location on a substrate for both low total gas flow and high total gas flow.

FIG. 5 is graph showing data for the APF bottom CD as a function of location on a substrate for two different H₂/N₂ ratios.

FIG. 6 is graph showing the APF etch profile as a function of source power.

FIG. 7 is graph showing data for the APF bottom CD as a function of location on a substrate for two different cathode temperatures. D

FIG. 8 is graph showing data for the APF bottom CD as a function of location on a substrate and as a function of neutral species tuning units (NSTU).

### DETAILED DESCRIPTION

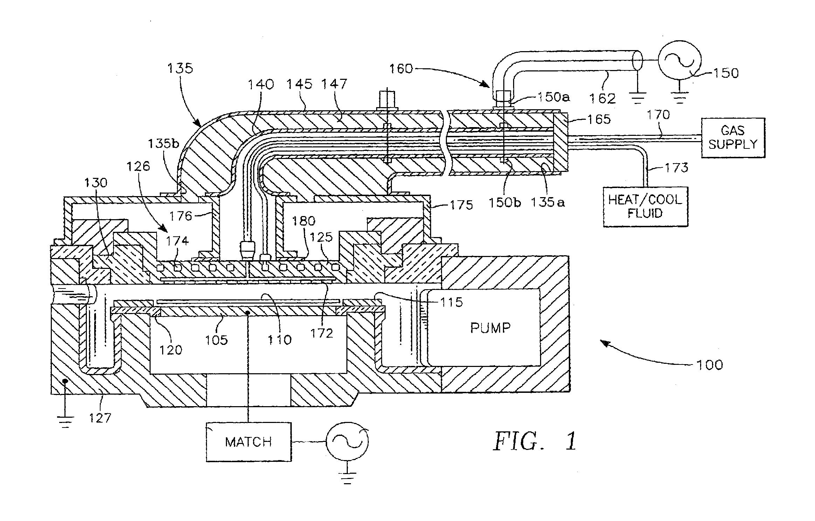

Embodiments of the present invention that take advantage of etching with APF as well as reducing bowing and providing bottom-to-top ratios are greater than 80%. Embodiments of the present invention can be performed in a capacitively coupled plasma processing chamber. Such a processing chamber is described in U.S. Patent No. 7,030,335 filed Dec. 19, 2001 by Daniel Hoffman et al. entitled "Plasma Reactor with Overhead RF Electrode Tuned to the Plasma" and assigned to the present assignee, the disclosure of which is incorporated herein by reference. A brief description of the capacitively coupled plasma processing chamber described in detailed in U.S. Patent No. 7,030,335 is provided with reference to FIG. 1, below. It is to be appreciated that enablement of the present invention can be performed in other processing chambers.

FIG. 1 is cross sectional view of a capacitively coupled plasma processing chamber 100 used to etch substrates in accordance with one embodiment of the invention. Plasma processing chamber 100 includes a substrate support 105 which is used to support a substrate 110. A semiconductor ring 115 surrounds the substrate 110. The semiconductor ring 115 is supported on the grounded chamber body 127 by a dielectric (quartz) ring 120. In one embodiment, the dielectric (quartz) ring 120 has a thickness of about 10 mm and dielectric constant of about 4. The chamber 100 is bounded at the top by a disc shaped overhead aluminum electrode supported at a predetermined gap length above the substrate 110 on grounded chamber body 127 by a dielectric (quartz) seal. The overhead electrode 125 can be a metal, such as aluminum, with its interior surface covered with a semi-metal material (e.g., Si or SiC). Alternatively, the interior surfaces can themselves be a semi-metal material. An RF generator 150 applies RF power to the electrode 125. RF power from the generator 150 is coupled through a coaxial cable 162 matched to the generator 150 and into a coaxial stub 135 connected to the electrode 125. The stub 135 has a characteristic impedance, resonance frequency, and provides an impedance match between the electrode 125 and the 50 Ohm coaxial cable 162 or the 50 Ohm output of the RF power generator 150, as is more fully described in U.S. Patent No. 7,030,335. The chamber body is connected to the RF return (RF ground) of the RF generator 150. The RF path from the overhead electrode 125 to RF ground is affected by the capacitance of the semiconductor ring 115, the dielectric ring 120 and the dielectric seal 130. The substrate support 105, the substrate 110 and the semiconductor ring 115 provide the primary RF return path for RF power applied to the electrode 125.

The capacitance of the overhead electrode assembly 126, including the electrode 125, the dielectric ring 120 and dielectric seal 130 measured with respect to RF return or ground can be 180 pico-farads. The electrode assembly capacitance is affected by the electrode area, the gap length (distance between substrate support and overhead electrode), and by factors affecting stray capacitances, especially the dielectric values of the seal 130 and of the dielectric ring 120, which in turn are affected by the dielectric constants and thicknesses of the materials employed. More generally, the capacitance of the electrode assembly is equal or nearly equal in magnitude to the negative capacitance of the plasma at a particular source power frequency, plasma density and operating pressure, as will be discussed below.

The coaxial stub 135 is configured to further contribute to the overall system stability, its wide process window capabilities, as well as many other valuable advantages. It includes an inner cylindrical conductor 140 and an outer concentric cylindrical conductor 145. An insulator 147, which is denoted by cross-hatching in FIG. 1 fills the space between the inner and outer conductors 140, 145. The inner and outer conductors 140, 145 are formed of nickel-coated aluminum. The outer conductor 145 can have a diameter of about 4 inches and the inner conductor 140 can have a diameter of about 1.5 inches. The stub characteristic impedance is determined by the radii of the inner and outer conductors 140, 145 and the dielectric constant of the insulator 147. In one embodiment, the stub 135 has a characteristic impedance of 65. More generally, the stub characteristic impedance exceeds the source power output impedance by about 20% 40%. The stub 135 has an axial length of about 29 inches, which is a quarter wavelength at 220 MHz, in order to have a resonance in the vicinity of 220 MHz to generally match while also being slightly offset from the VHF source power frequency of 210 MHz.

A tap 160 is provided at a particular point along the axial length of the stub 135 for applying RF power from the RF generator 150 to the stub 135. The RF power terminal 150b and the RF return terminal 150a of the generator 150 are connected at the tap 160 on the stub 135 to the inner and outer coaxial stub conductors 140 and 145, respectively. These connections are made via a generator-to-stub coaxial cable 162 having a characteristic impedance that matches the output impedance of the generator 150 (e.g. about 50 ohms). A terminating conductor 165 at the far end 135a of the stub 135 shorts the inner and outer conductors 140 and 145 together, so that the stub 135 is shorted at its far end 135a. At the near end 135b, which is the un-shorted end of the stub 135, the outer conductor 145 is connected to the chamber body via an annular conductive housing or support 175, while the inner conductor 140 is connected to the center of electrode 125 via a conductive cylinder or support 176. A dielectric ring 180 is held between and separates the conductive cylinder 176 and the electrode 125.

The inner conductor 140 can provide a conduit for utilities such as process gases and coolant. The principal advantage of this feature is that, unlike typical plasma processing chambers, the gas line 170 and the coolant line 173 do not cross large electrical potential differences. Since this design allows for smaller potential differences, the conduits can be made of metal, which is less expensive and a more reliable material for such a purpose. The metallic gas line 170 feeds gas inlets 172 in or adjacent the overhead electrode 125 while the metallic coolant line 173 feeds coolant passages or jackets 174 within the overhead electrode 125. The gas inlets gas inlets 172 in or adjacent the overhead electrode 125 can be configured as inner and outer gas distribution manifolds. In one embodiment the inner and outer gas distribution manifolds form and inner ring and an outer ring where the flow to each ring can be adjusted. Such as gas distribution system allows for better uniformity across a wafer because the gas flow to the inner part of the wafer can be adjusted relative to the gas flow going to the outer part of the wafer.

In one working example, the neutral species was Argon, the plasma electron frequency was about 230 MHz, the RF source power frequency was about 210 MHz with chamber pressure in the range of 10 millitorr to 200 millitorr with sufficient RF power applied so that the plasma density was between 10⁹ and 10¹² cc⁻¹. Under these conditions, the plasma generally has a negative capacitance -50 to -400 pico-farads. The plasma capacitance can be adjusted and optimized for different applications such as dielectric etch, metal etch and CVD, to certain desired ranges, and to have a negative value at VHF source power frequencies. By exploiting these characteristics of the plasma, the processing conditions can be optimized by matching the electrode capacitance and frequency-matching features of the processing chamber.

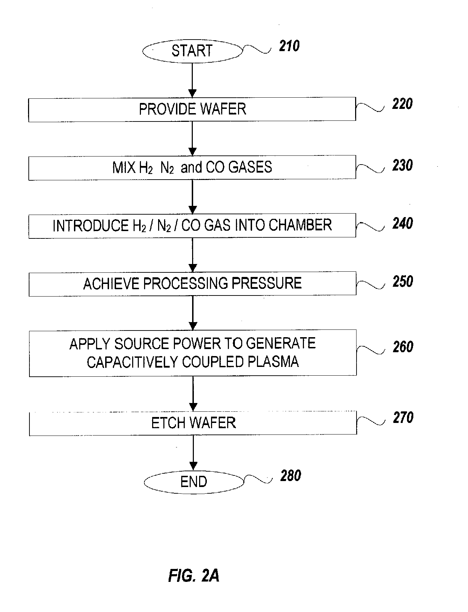

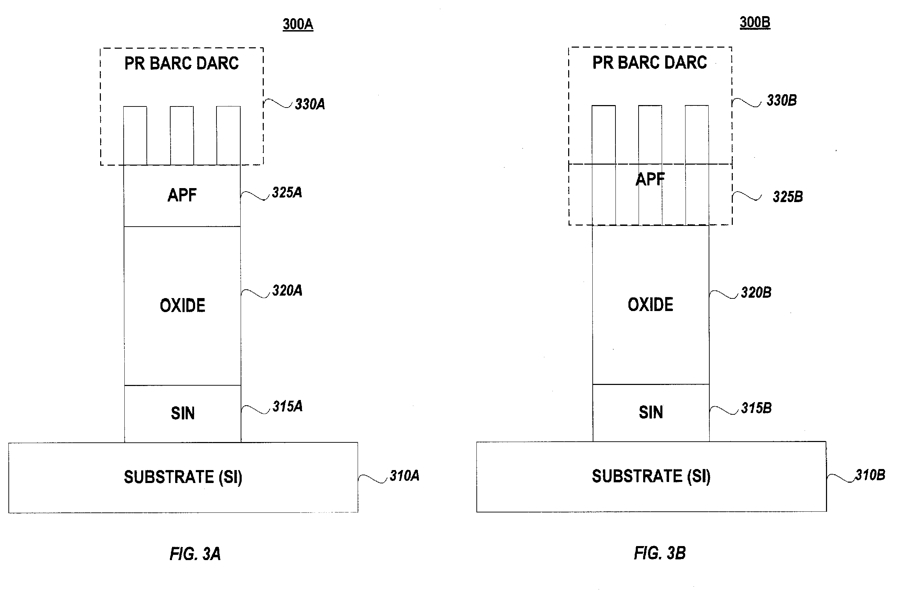

FIG. 2A is a flow chart showing an exemplary method used to etch an APF with high photoresist mask (PR) selectivity and high etch rate using a capacitive coupling high frequency plasma dielectric etch chamber, in accordance with one embodiment of the invention. The processes illustrated in the flow chart of FIG. 2A can be used during the manufacture of a CMOS device 300, as discussed with reference to FIG. 3 below. The method starts at 210 when the etch system is prepared for receiving a partially fabricated CMOS device 300. At 220, a partially fabricated CMOS device is introduced into a process chamber by transporting the wafer onto a pedestal such as an electrostatic chuck. The partially fabricated CMOS wafer has already undergone several processes including the deposition, patterning and etching of the photoresist, bottom anti-reflective layers, and the dielectric anti-reflective layers (PR BARC DARC) 330A. The (PR BARC DARC) 330A can be etched in the same to produce the pattern shown in the same chamber as the APF is to be etched. The chemistries used to etch the (PR BARC DARC) layer 330A described in further detail with reference to FIG. 3A below.

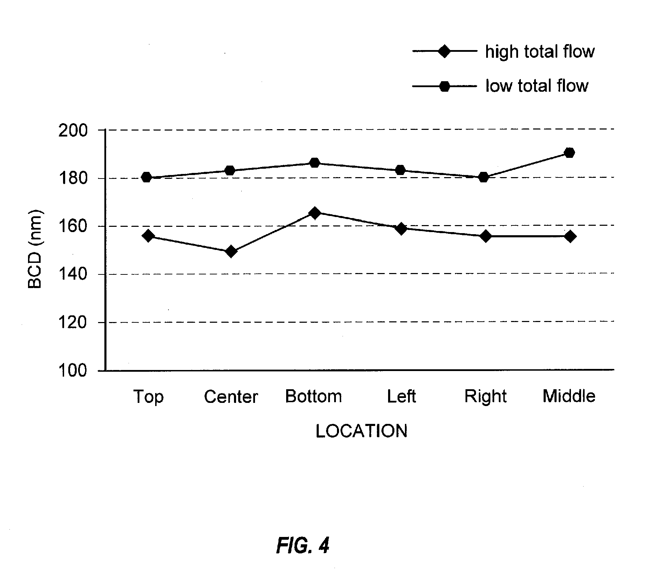

At 230, H₂, N₂ and CO gasses are mixed. The mixing of H₂, N₂ and CO gasses can be performed by supplying individual gases of H₂, N₂ and CO and allowing them to mix in a chamber before they are introduced into the process chamber. Alternatively, the H₂, N₂ and CO gasses can be premixed, stored in a cylinder and supplied to the process chamber as needed. Next at 240, the H₂/N₂/CO gas mixture is introduced into the process chamber. In the process chamber illustrated in FIG. 1, the H₂/N₂/CO gas mixture is introduced into the processing chamber through gas line 170 and gas inlets 172. Gas inlets 172 can include inner and outer distribution rings which allow the gas flow to be adjusted differently over the center of the wafer and the edges of the wafer. In one embodiment, the gas mixture is prepared by mixing about 300 sccm of H₂, about 300 sccm of N₂, and between 25 - 100 sccm of CO. If 50 sccm of CO is used then this mixture can be set up so that the ratio of H₂:N₂ is 1:1. In other embodiments the ratio H2:N2 ranges from 1:3 to 1:1 and the ratio of N2:CO ranges from 6:1 1 to 3:1. At 250, the processing pressure is reached by adjusting the flow rate, the pumping speed or both. Since the flow rate can affect wafer properties as further described below with reference to FIG. 4, the flow rate can be set to a specific value and pumps and valves can be used to adjust the pressure. For example, the pressure can be adjusted by throttling a valve going to the vacuum pump. If a lower pressure is desired then a valve going to the vacuum pump can be opened and if a higher pressure is desired the valve can be closed. In one embodiment, the H₂/N₂/CO gas mixture flow rate is set between 250 sccm to 1300 sccm and the pressure is maintained between 20 millitorr and 200 millitorr. In one specific example, the pressure is maintained at about 100 millitorr.

Next, at 260, a source power is used to generate a conductively coupled plasma. The source power ranges from 0 watts to 2300 watts depending on the application. In one specific application, the source power is set to 2000 watts. Once these processing conditions are established and the plasma has been generated, the wafer is etched at 270. The etching can be controlled by either measuring time or endpoint detection. If a timer is used then the wafer is etched for some time which has already been predetermined to etch the correct amount of material. If endpoint detection is used to stop the process, then the substrate is etched until the endpoint detector determines that enough material has been etched from the wafer. In one embodiment, etching is stopped by shutting off the gas flow, and the source power. Once the etching process is complete, the etched wafer is removed from the etch chamber in step 280 and sent on to the next process.

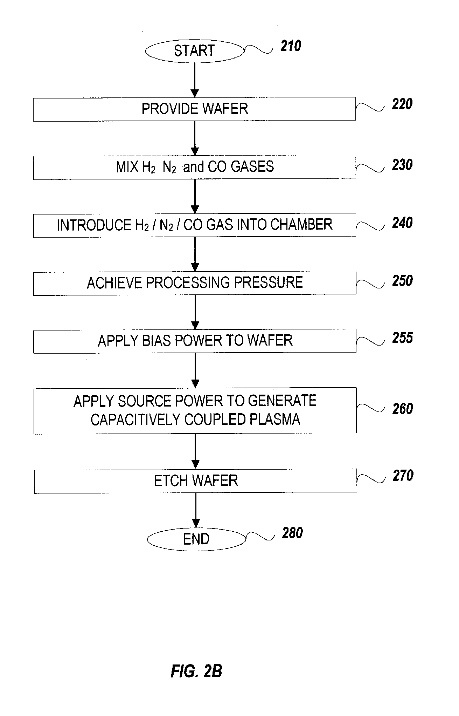

FIG. 2B is a flow chart showing another exemplary method similar to that described with relation to FIG. 2A used to etch an APF along with the addition of applying a bias power, in accordance with another embodiment of the invention. In this embodiment of the invention the wafer is etched as described above with reference to FIG. 2A but with bias power supplied to the wafer. The advantages of supplying a bias power to the wafer during etching are described below with reference to FIG. 4 through FIG. 8. Supplying a bias power to the wafer is performed by using an electrostatic chuck or some other wafer support that is coupled to a power source capable of biasing the wafer, in one embodiment. The bias power can be supplied by an RF power supply that generates 13.56 MHz power. The bias power can range from 0 watts and 1000 watts. In one specific application, the bias power is about 900 watts.

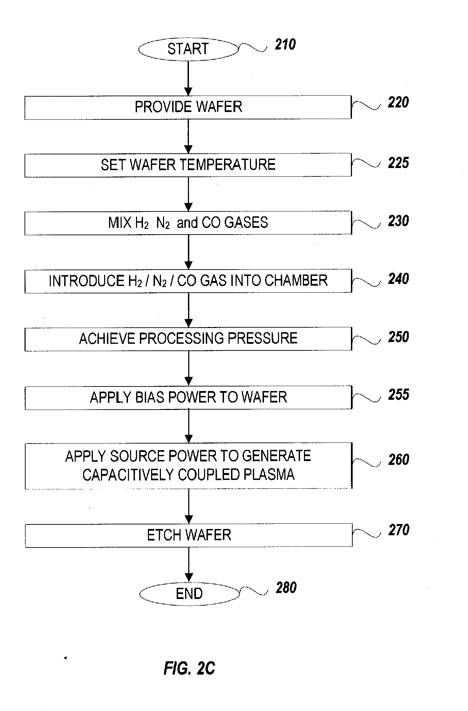

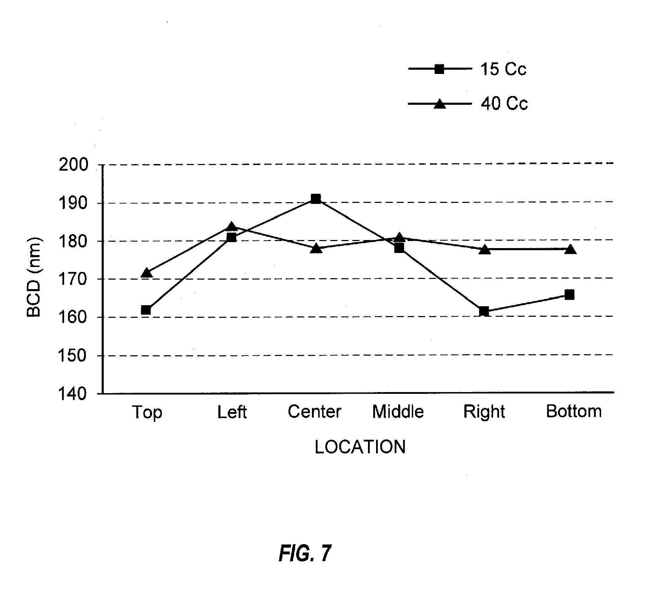

FIG. 2C is a flow chart showing yet another exemplary method similar to that described with relation to FIG. 2B used to etch an APF along with the addition of adjusting the temperature of the substrate, in accordance with another embodiment of the invention. In this embodiment of the invention the wafer is etched as described above with reference to FIG. 2B but with bias power supplied to the wafer. The advantages of adjusting the wafer temperature during etching are described below with reference to FIG. 7. Adjusting the temperature of the wafer to be between 20 °C and 60 °C is done by heating the wafer with a heater, in one embodiment. The heater can be a resistive heater located within the electrostatic chuck or some other heater such as a lamp.

FIG. 2A, 2B, and 2C show various processes such as introducing gas to the process chamber at 240, achieving process pressure at 250, applying a bias power to the wafer at 235, setting the wafer temperature at 225, and applying a source power to generate a capacitively coupled plasma at 260. This invention is not limited to any one specific order to performing these mentioned processes. The order of these processes can be interchanged according to different embodiments of the invention. For example it may be advantages to set the wafer temperature before introducing the gas mixture. Alternatively in may be advantages to apply a bias power before introducing the gas mixture.

FIGs. 3A-3B show a gate electrode stack both before etching and after etching using etching techniques, in accordance with one embodiment of the invention.

FIG. 3A illustrates a partially fabricated CMOS device 300 before etching the APF layer including a substrate 310A, a SiN layer 315A, an oxide layer 320A, an APF layer 325A, and a PR BARC/DARC layer 330A. APF layers generally comprise films of SiON and carbon. PR BARC/DARC layers generally comprise photoresist (PR) layers, bottom anti-reflective coating (BARC) layers, and dielectric anti-reflective coating (DARC) layers. BARC layers include light-absorbing metal layer (typically titanium nitride), deposited on top of metal or polysilicon, to improve photolithography performance. DARC layers include non-reflective, non-energy-absorbing, inorganic dielectric layer deposited on top of metal or polysilicon to improve photolithography performance. DARC layers make it possible to accurately transfer the mask pattern onto the photoresist.

In one embodiment of the present invention, the substrate 310A can be a silicon substrate. If the CMOS device is a PMOS then the substrate can be an n-type substrate whereas if the CMOS device is an NMOS then the substrate can be a p-type substrate. The SiN layer 315A, which serves as barrier layer, is deposited directly onto the substrate 310A. The oxide layer 320A is deposited after the SiN layer 315A so that the SiN layer 315A is located below the oxide layer 320A. In some embodiments, the oxide layer 320A includes silicon dioxide layer that is doped with both boron and phosphorous, which is referred to as a boro-phospho-silicate glass (BPSG) layer. The SiN layer 315A serves as a barrier to diffusion of boron and phosphorous from the BPSG layer into the substrate 310A. The diffusion can occur during high temperature processes such as reflow and densification of the BPSG layer itself.

The APF layer 325A is deposited after the oxide layer 320A so that the APF layer 325A is located above the oxide layer 320A. The APF layer 325A is a strippable hardmask such as an amorphous carbon/DARC stack film. The PR BARC/DARC layer 330A is deposited after the APF layer 325A so that the PR BARC/DARC layer 330A is located above the APF layer 325. The PR BARC/DARC layer 330A is a photoresist layer that has been patterned for further etching of the stack below the photoresist.

The PR BARC/DARC layer 330A includes a pattern which has been formed by etching away portions of the layer. PR BARC/DARC layer 330A has been etched using CF₄/CHF₃ etchants.

FIG. 3B illustrates the partially fabricated CMOS device 300B illustrated in FIG. 3A after the APF layer has been etched with the methods described with reference to FIGS. 2A-2C, in accordance with one embodiment of the invention. The APF layer 325B has been etched using H₂/N₂/CO gas mixtures to make CMOS device 300B. The remainder of the structure is etched later using different etchants. For example, the oxide layer 320A is etched using etchants such as C₄F₆/C₄F₈. Similarly, the SiN layer 315A is etched using CH₂F₂/CHF₃ etchants.

In one application the contact openings are etched through the oxide layer 320B, which includes BPSG, and the SiN layer 315B using multiple etch processes or a two-etch process method. In one embodiment, the first etch selectively etches silicon dioxide in the oxide layer 320B relative to silicon nitride in the SiN layer 315B, and stops on the SiN 315B layer. In addition to serving as an etch stopping layer, the SiN layer 315B also protects the underlying active regions from being damage by ionized oxygen released during oxide etch. After the etching is complete, a nitride etch step is used to clear the SiN layer 315B, without damaging the sidewalls of the semiconductor device structure.

FIG. 4 is graph showing data for the APF bottom critical dimension (BCD) as a function of location on a substrate for both low total gas flow and high total gas flow. FIG. 4 illustrates that a higher total flow of the H₂/N₂/CO gas mixture produces a bad profile and smaller bottom CD compared to a lower total flow of the H₂/N₂/CO gas mixture. Additionally, the bottom CD is also worse with a higher flow rate of H₂/N₂/CO gas mixture than with a lower flow rate. By lowering the flow rate of H₂/N₂/CO gas mixture, the vertical profile as well as the CD uniformity is improved. Embodiments of the present invention improve the bottom CD uniformity and minimize or eliminate the undercut by adjusting the total flow rate. These methods further improve the vertical profile for features formed.

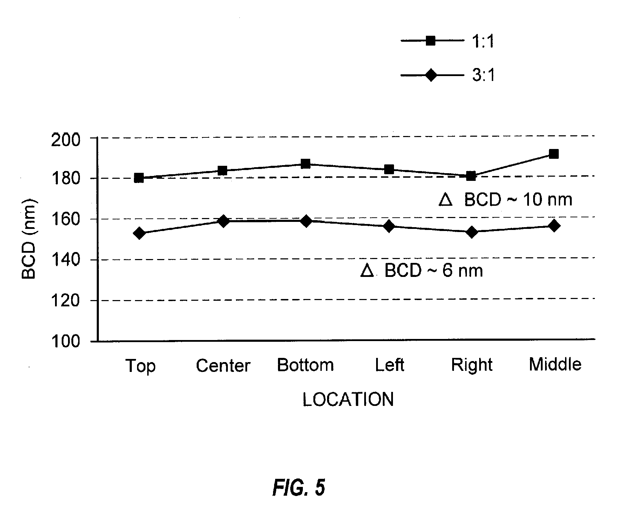

FIG. 5 is graph showing data for the APF bottom CD as a function of location on a substrate for two different H_{2/}N₂ ratios. FIG. 5 illustrates that a lower H_{2/}N₂ ratio in the H₂/N₂/CO gas mixture results in better bottom CD uniformity. In FIG. 5 data for ratios of H₂/N₂ = 1:1 and H₂/N₂ = 3:1 are presented. Processing wafers with a gas mixture of H₂/N₂ = 1:1 1 results in a smaller bottom CD with less variation then processing wafers with a gas mixture of H₂/N₂ = 3:1.

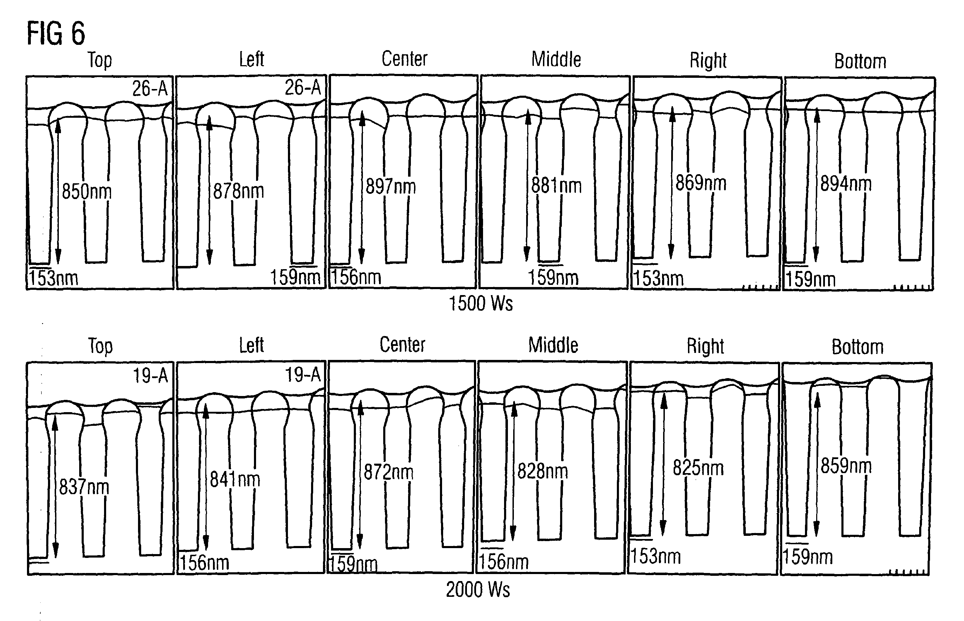

In some applications it may be advantageous to combine a lower total flow of the H₂/N₂/CO gas mixture and lower H₂/N₂ ratio to get both a good profile and good uniformity. In another embodiment of the invention, the higher source power can be used to improve the uniformity wither in conjunction or instead of the lower H₂/N₂ ratio as will be discussed below with reference to FIG. 6.

Processing wafers with lower H₂/N₂ ratios also improve particle control which results in higher yields. In one example of an APF etch step using an H₂/N₂/CO gas mixture, the particle adders ranged from 50 to 150, averaging 100. In this example, no spike or upward trend in particle during the etch process. The source of particle is suspected from the H₂/N₂ reaction with the fluorine (F) by-product prior to the APF step. This reaction is likely the source of the particles because H will react with F inside the chamber forming the nonvolatile by product. Since a lower H₂/N₂ ratio results in less H in the chamber, there is less chance of a reaction between the H and F and therefore less chance of forming particles which results in improved particle control.

FIG. 6 is graph showing the APF etch profile as a function of source power. FIG. 6 illustrates that the etch rate (ER) and etch rate uniformity percentage (ER U%) improve from 4310A/min and 7.7% to 5490A/min and 3.1% as the source power increases from1500 watts to 2000 watts. The ER is 27% faster when the source power is increased by 500 watts. Increasing the source power from 1500 watts to 2000 watts does not impact on the bottom CD and uniformity, but does result in a better profile.

The bias power can also have an affect on the wafer properties. In one embodiment a 13.56 MHz bias power is supplied to the wafer. Increasing the bias power can severely impact the dielectric antireflective coating (DARC) selectivity. For example, when the 13.56 MHz bias power is raised from 900 watts to 1500 watts, the DARC layer is entirely removed, which result in a top flare APF profile. Therefore, a reduction in the bias power can result in improved DARC integrity.

FIG. 7 is graph showing data for the APF bottom CD as a function of location on a substrate for two different cathode temperatures. FIG. 7 illustrates that when the cathode temperature is changed from 40°C to 15°C the profile of the bottom CD becomes worse. The temperature effect on the bottom CD uniformity is due to a slower DARC ER during the APF etch step at higher temperatures. However, since the temperature increase does not produce a major impact on the bottom CD seems, the etch uniformity affect may be due to more OE% at the same step time for 15°C. Moreover, the APF is etched faster and more uniformly, as measured between the wafer center and wafer edge, when the cathode temperature is set at 40°C instead of when the cathode temperature is set at 15°C.

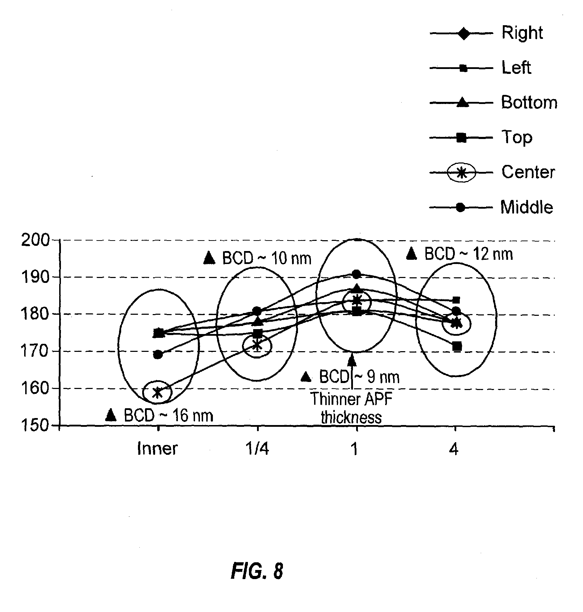

FIG. 8 is graph showing data for the APF bottom CD as a function of location on a substrate and as a function of neutral species tuning units (NSTU). The NSTU is used to control the gas flow ratio by means of a dual zone showerhead. In one embodiment, the standard NSTU is defined as the ratio of gas flowing into the outer edge of the wafer to the gas flowing to center of the wafer. For example, in this embodiment 3 NSTU means that 75% of the total gas flows to the outer edge of the wafer and 25% of the gas flows to center of the wafer. The NSTU is used to tune center and edge difference caused by polymer distribution, which in turn can affect etch performances such as profiles, CD, PR selectivity, residue, or even etch rate. FIG. 8 illustrates that the that the bottom CD is more uniform when the NSTU ranges up to 1, but becomes less uniform when the NSTU ranges from 1 to 4. Additionally, the bottom CD range across a whole wafer is small with an NSTU setting of one.

FIG. 4 through FIG. 8 illustrate that adjusting the flow rate in a process using an H₂/N₂/CO gas mixture can result in a high APF etch rate, a high PR selectivity, and a controlled APF mask CD. Additionally, combining an H₂/N₂/CO gas mixture process with high and low frequency RF power enlarges the process window. Combining the H₂/N₂/CO gas mixture process with dual gas feed lid, the NSTU, and CSTU improves etch rate uniformity. Moreover, a process using a lean H₂/N₂/CO gas mixture chemistry eliminates polymer formation, which increases chamber up time.

It will also be recognized by those skilled in the art that, while the invention has been described above in terms of preferred embodiments, it is not limited thereto. Various features and aspects of the above-described invention may be used individually or jointly. Further, although the invention has been described in the context of its implementation in a particular environment and for particular applications, those skilled in the art will recognize that its usefulness is not limited thereto and that the present invention can be utilized in any number of environments and implementation.

## Claims

1. A method of etching an advanced pattern film (APF), comprising:
providing a wafer comprising an APF layer into a processing chamber, wherein said processing chamber is configured with a power source in particular operating at about 162 MHz.;
supplying a process gas into said chamber, wherein said process gas comprises hydrogen gas (H₂), nitrogen gas (N₂), and carbon monoxide gas (CO) and the ratio of H₂:N₂ is about 1:1;
applying a source power using said power source; and
applying a bias power to said wafer.

2. The method of claim 1 wherein said process gas is prepared by mixing 300 sccm of H₂, 300 sccm of N₂, and 25 - 100 sccm of CO prior to supplying the process gas into the processing chamber.

3. The method of claim 1 or 2 wherein said process gas is prepared by mixing 300 sccm of H₂, 300 sccm of N₂, and 50 sccm of CO prior to supplying the process gas into the processing chamber.

4. The method of one of the claims 1 to 3 wherein said source power ranges between 0 watts and 2300 watts.

5. The method of one of the claims 1 to 4 wherein said bias power ranges between 0 watts and 1000 watts.

6. The method of one of the claims 1 to 5 further comprising maintaining a process pressure of about 100 millitorr.

7. A method of etching an advanced pattern film (APF), comprising:
providing a wafer comprising an APF layer into a processing chamber, wherein said processing chamber is configured with a power source in particular operating at about 162 MHz.;
supplying a process gas into said chamber, wherein said process gas comprises hydrogen gas (H₂), nitrogen gas (N₂), and carbon monoxide gas (CO) and the ratio of H₂:N₂ is about 3:1;
applying about 2000 watts of power to said power source operating in particular at 162 MHz;
applying a bias of about 900 watts to said wafer; and
maintaining a process pressure of about 100 millitorr.

8. The method of claim 7 wherein said process gas is prepared by mixing 450 sccm of H₂, 150 sccm of N₂, and 25 - 100 sccm of CO prior to supplying the process gas into the processing chamber.

9. A method of etching an advanced pattern film (APF), comprising:
providing a wafer comprising an APF layer into a processing chamber, wherein said processing chamber is configured with a power source in particular operating at about 162 MHz.;
adjusting the temperature of the wafer to be between 20 °C and 60 °C;
supplying a process gas into said chamber, wherein said process gas comprises hydrogen gas (H₂), nitrogen gas (N₂), and carbon monoxide gas (CO);
applying a source power using said power source;
applying a bias power to said wafer; and
maintaining a process pressure of about 100 millitorr.

10. The method of claim 9 wherein said H₂ and said N₂ in said process gas has a ratio of H₂:N₂ of about 1:1.

11. The method of claim 10 wherein said process gas is prepared by mixing 300 sccm of H₂, 300 sccm of N₂, and 25 - 100 sccm of CO prior to supplying the process gas into the processing chamber.

12. The method of one of the claims 9 to 11 wherein said H₂ and said N₂ in said process gas has a ratio of H₂:N₂ of about 3:1.

13. The method of claim 12 wherein said process gas is prepared by mixing 450 sccm of H₂, 150 sccm of N₂, and 25 - 100 sccm of CO prior to supplying the process gas into the processing chamber.

14. The method of one of the claims 9 to 13 wherein said source power ranges between 0 watts and 2300 watts.

15. The method one of the claims 9 to 14 wherein said bias power ranges between 0 watts and 1000 watts.
